# EUROPÄISCHE PATENTSCHRIFT

(11) **EP 2 005 201 B1**
(45) Veröffentlichungstag und Bekanntmachung des Hinweises auf die Patenterteilung: **27.04.2011**
(21) Anmeldenummer: 07727491.8
(22) Anmeldetag: 29.03.2007
(51) Int. Cl.: G01R 19/32

(54) **VERFAHREN ZUM MESSEN EINES MITTELS WECHSELRICHTER ERZEUGTEN WECHSELSTROMES UND ANORDNUNG ZUR DURCHFÜHRUNG DES VERFAHRENS**
METHOD FOR MEASURING AN ALTERNATING CURRENT WHICH IS GENERATED USING INVERTERS, AND ARRANGEMENT FOR CARRYING OUT THE METHOD
PROCÉDÉ POUR MESURER UN COURANT ALTERNATIF GÉNÉRÉ AU MOYEN D'UN ONDULEUR ET ARRANGEMENT POUR METTRE EN OEUVRE LE PROCÉDÉ

(30) Priorität: 13.04.2006 DE 102006017479
(43) Veröffentlichungstag der Anmeldung: 24.12.2008
(73) Patentinhaber: Siemens Aktiengesellschaft, 80333 München (DE)
(72) Erfinder: HALLAK, Jalal, A-1220 Wien (AT)
(74) Vertreter: Maier, Daniel Oliver
(86) Internationale Anmeldenummer: PCT/EP2007/053019
(87) Internationale Veröffentlichungsnummer: WO 2007/118779

(56) Entgegenhaltungen:
- DE-A1- 19 535 271
- DE-A1- 19 905 271
- DE-A1-102004 041 766
- JP-A- 2003 121 479

## Beschreibung

Die Erfindung betrifft ein Verfahren zum Messen eines mittels Wechselrichter erzeugten Wechselstromes, welcher in ein Wechselstromnetz eingespeist wird, wobei ein Nulldurchgangssignal des Wechselstromnetzes vorgegeben wird. Des Weiteren betrifft die Erfindung eine Anordnung zur Durchführung des Verfahrens.

Wechselrichter werden in der Regel dazu eingesetzt, Energie aus Gleichstromquellen in Wechselströme umzuformen und diese in Wechselstromnetze einzuspeisen oder an Lasten abzugeben. Dabei werden der Spannungsverlauf und der Phasenwinkel an die Wechselspannung im Netz angepasst, sodass Gleichspannungsanteile und Phasenverschiebungen minimiert werden. Das ist vor allem bei öffentlichen Stromnetzen wichtig, da hier von den Netzbetreibern genaue Einspeiserichtlinien mit maximal zulässigen Gleichspannungsanteilen vorgegeben werden.

Um den Wechselrichter entsprechend regeln zu können, wird deshalb laufend der Nulldurchgang im Netz detektiert und als Nulldurchgangssignal vorgegeben. Am Ausgang des Wechselrichters wird zudem als Regelgröße der Wechselstrom gemessen. Bei den dabei eingesetzten Messschaltungen, die beispielsweise Shuntwiderstände oder Stromwandler umfassen, kann es zu bauteilbedingten Ungenauigkeiten kommen. Das kann z.B. eine unerwünschte Offsetspannung bei Stromwandlern oder eine Temperaturdrift sein. Nach dem Stand der Technik kennt man deshalb Verfahren, um die Messschaltungen abzugleichen.

Ein Verfahren besteht beispielsweise darin, jede Messschaltung nach der Fertigung manuell abzugleichen. Andere Verfahren nutzen Mikrocontroller, die nach jedem Einschaltvorgang einen Abgleichvorgang durchführen.

Bei Messschaltungen, die zur Erfassung des Stromes Shuntwiderstände nutzen, sind die an den Shuntwiderständen auftretenden Verluste zu berücksichtigen.

Die DE 10 2004 041 766 offenbart ein Verfahren zum Messen eines Wechselstromes, wobei ein Nulldurchgangssignal des Wechselstromes vorgegeben wird und wobei ausgelöst vom Nulldurchgangssignal ein periodischer Abgleich des Messsignals in der Weise erfolgt, dass ein dem Nulldurchgangssignal zugeordneter Abgleichwert vorgegeben wird, mit dem das Messsignal bis zum Beginn der nächsten Abgleichperiode abgeglichen wird.

Nach dem Stand der Technik ist deshalb bei Wechselrichtern höherer Leistung der Einsatz von Stromwandlern vorgesehen, um den Strom am Ausgang des Wechselrichters zu messen. Für diese Stromwandler werden zur Eliminierung einer unerwünschten Offsetspannung Verfahren mit manuellem Abgleich bei der Fertigung eingesetzt. Es sind aber auch Verfahren bekannt, bei welchen ein in die Messschaltung integrierter Mikrocontroller zum Abgleich des Stromwandlers bei jedem Einschaltvorgang des Geräts genutzt wird.

Mit diesen Verfahren werden jedoch keine Abweichungen infolge Temperaturdrift oder Restmagnetisierung des Stromwandlerkerns aufgehoben. Die Restmagnetisierung wird dabei durch Änderungen der Stromrichtung aufgrund der Hysterese des Stromwandlerkerns verursacht. Im Betrieb erzeugte Wärme oder äußere Temperaturveränderungen führen zur Temperaturdrift, d.h. es kommt zu Ungenauigkeiten des Stromwandlers, die auf temperaturabhängige Eigenschaften der Stromwandlerbauteile zurückzuführen sind.

Der Erfindung liegt die Aufgabe zugrunde, für ein Verfahren der eingangs genannten Art eine Verbesserung gegenüber dem Stand der Technik anzugeben. Zudem soll eine Anordnung zur Durchführung des Verfahrens angegeben werden.

Gelöst wird diese Aufgabe durch ein Verfahren zum Messen eines mittels Wechselrichter erzeugten Wechselstromes, welcher in ein Wechselstromnetz eingespeist wird, wobei ein Nulldurchgangssignal des Wechselstromnetzes vorgegeben wird, wobei ausgelöst vom Nulldurchgangssignal ein periodischer

Abgleich des gemessenen Wechselstromes in der Weise erfolgt, dass ein dem Nulldurchgangssignal zugeordneter Abgleichwert vorgegeben wird, dem ein in gleicher Weise dem Nulldurchgangssignal zugeordneter Messwert angeglichen wird.

Dieses Verfahren ermöglicht auch während des Betriebs einen periodischen Abgleich des von einer Messschaltung erfassten Messsignals mit einem Abgleichwert. Der Abgleich wird dabei mittels Nulldurchgangssignal des Wechselstromnetzes gesteuert. Damit erreicht man einerseits, dass der Abgleich synchron zum Wechselstromnetz erfolgt und dass auch durch Temperaturdrift oder Restmagnetisierung verursachte Abweichungen ausgeglichen werden.

In einer vorteilhaften Ausgestaltung der Erfindung wird jedem Nulldurchgang des Netzstromes ein Abgleichwert gleich Null Ampere zugeordnet und jeder beim Nulldurchgang des Netzstromes erfasste Messwert wird diesem Abgleichwert angeglichen. Der Abgleich erfolgt dann bei jedem Nulldurchgang des Netzstromes. Eine Festlegung des Abgleichwertes auf Null Apere bewirkt zudem, dass der am Wechselrichterausgang gemessene Strom ohne einen durch Ungenauigkeiten verursachten Gleichstromanteil gemessen wird. Somit steht der Regelung des Wechselrichters ein genaues Messausgabesignal zur Verfügung, sodass die Einspeisung in das Wechselstromnetz synchron zum Netzstrom und ohne Gleichstromanteile erfolgt.

Der Abgleich während des Nulldurchgangs nutzt zudem eine Eigenart des mittels Wechselrichter erzeugten Wechselstromes. Bei der Umkehrung der Stromrichtung bleibt der Stromwert für die Zeit des Umschaltvorganges der Schaltelemente konstant. Diese Zeitspanne wird zum Abgleich des Messsignals genutzt.

Vorteilhaft ist es zudem, wenn bei jedem Abgleich aus dem Abgleichwert und dem erfassten Messwert ein Korrekturwert ermittelt wird und wenn bis zum nächsten Abgleich als Messausgabesignal das mit dem Korrekturwert berichtigte Messsignal ausgegeben wird. Dies stellt eine einfache Methode zum Abgleich des Messsignals dar, die entweder mittels einer diskreten Schaltung oder mittels eines Mikrocontrollers durchführbar ist.

Für ein Wechselstromnetz ohne Phasenverschiebung, d.h. ohne Blindstromanteil, ist es von Vorteil, die Messwerte zu den Zeitpunkten der Nulldurchgänge mit dem Abgleichwert abzugleichen. Die Einspeisung in das Wechselstromnetz erfolgt dann synchron zum Nulldurchgangssignal ohne Gleichstromanteile.

Bei der Einspeisung des von einem Wechselrichter erzeugten Stromes in ein Inselnetz ist infolge nicht ausgleichbarer Impedanzen in der Regel eine Phasenverschiebung zwischen Netzspannung und Netzstrom gegeben. Dann werden die Messwerte vorteilhafterweise zu den Zeitpunkten der Nulldurchgänge des Netzstromes mit dem Abgleichwert abgeglichen.

Dabei ist es günstig, die Zeitpunkte der Nulldurchgänge des Netzstromes durch Erfassen der Netzspannung und der Phasenverschiebung zu bestimmen, da die Erfassung der Netzspannung ohnehin innerhalb der Wechselrichteranordnung als Vorgabe für die Stromeinspeisung erforderlich ist.

Die Aufgabe wird des Weiteren mit einer Anordnung gelöst, die zur Durchführung der beanspruchten Verfahren eingerichtet ist, wobei zur Messung des Wechselstromes ein Stromwandler vorgesehen ist und wobei am Eingang des Stromwandler der vom Wechselrichter erzeugte Wechselstrom anliegt und wobei am Ausgang eine Spannung als Messsignal anliegt und wobei das Messsignal in Abhängigkeit vom Nulldurchgangssignal periodisch dem Abgleichwert angeglichen ist. Der laufend abgeglichene Stromwandler arbeitet dabei nahezu verlustfrei, wodurch sich der Gesamtwirkungsgrad des Wechselrichters gegenüber Messschaltungen mit Shuntwiderstand verbessert.

In einer vorteilhaften Ausgestaltung der Anordnung ist ein Mikrocontroller mit wenigstens zwei Eingängen vorgesehen, wobei an einem ersten Eingang das vom Stromwandler erzeugte Messsignal sowie an einem zweiten Eingang das Nulldurchgangssignal anliegen und wobei des Weiteren dem Mikrocontroller ein dem Stromwert von Null Ampere zugeordneter Spannungswert des Stromwandlers als Abgleichwert vorgegeben wird und wobei an einem Ausgang des Mikrocontrollers ein mit dem Korrekturwert berichtigtes Messausgabesignal abgreifbar ist. Der Einsatz des Mikrocontrollers erlaubt eine einfache Anordnung, die leicht an unterschiedliche Wechselrichter mit verschiedenen Stromwandlern anpassbar ist.

Abhängig von den zu fertigenden Stückzahlen kann es auch vorteilhaft sein, wenn ein so genannter Sample und Hold Verstärker vorgesehen ist, an dessen Eingängen das Messsignal aus dem Stromwandler und das Nulldurchgangssignal anliegen und wenn als Ausgangssignal ein Korrekturwert anliegt, der dem positiven Eingang eines Operationsverstärkers zugeführt ist und wenn des Weiteren am negativen Eingang des Operationsverstärkers das Messsignal anliegt, sodass am Ausgang des Operationsverstärkers das berichtigte Messausgabesignal abgreifbar ist. Bei dieser mit diskreten Bauteilen aufgebauten Schaltung ist kein Mikrocontroller erforderlich.

Die Erfindung wird nachfolgend in beispielhafter Weise unter Bezugnahme auf die beigefügten Figuren erläutert. Es zeigen in schematischer Darstellung:
- Fig. 1:: Anordnung zum Abgleich des Messsignals U₀ mittels diskreter Bauelemente
- Fig. 2:: Signalverlauf des Stromes I_{NETZ} im Wechselstromnetz und abgeleitetes Nulldurchgangssignal Sig

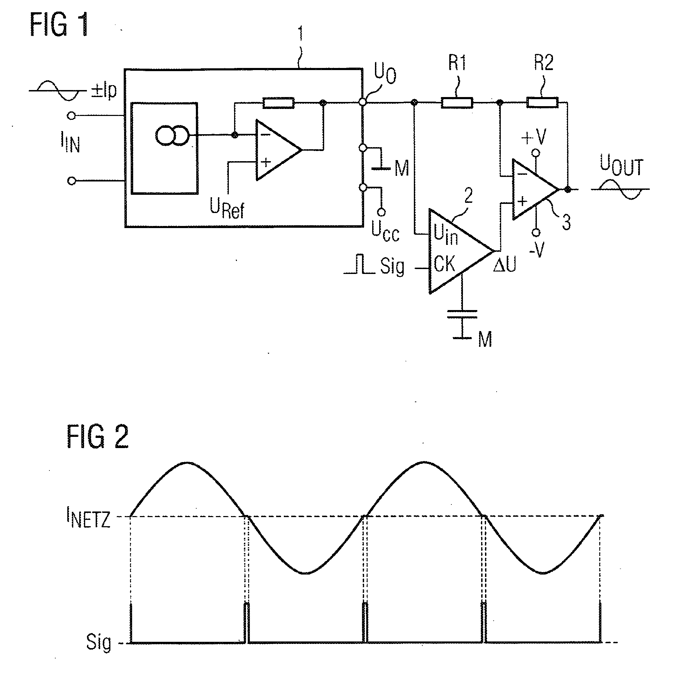

In Figur 1 ist eine Anordnung zur Messung eines mittels Wechselrichter erzeugten Wechselstroms ±Ip mittels Stromrichter 1 dargestellt. Das Messsignal U₀ am Ausgang des Stromrichters 1 ist an den Eingang Uᵢₙ eines so genannten Sample und Hold Verstärkers 2 angeschlossen. Der Zeitgeber-Eingang CK des Sample und Hold Verstärkers 2 ist mit dem Nulldurchgangssignal Sig beaufschlagt. Des Weiteren ist der Sample und Hold Verstärker 2 über einen Kondensator mit einem Massepotenzial M als Reverenzpotenzial verbunden. Der Ausgang des Sample und Hold Verstärkers 2 ist mit dem positiven Eingang eines Operationsverstärkers 3 verbunden. Dieser wird mit einer positiven und negativen Spannung +V, -V versorgt. Am negativen Eingang des Operationsverstärkers 3 liegt das vom Stromwandler 1 ausgegebene Messsignal U₀ über einen ersten Widerstand R1 an. Der Ausgang des Operationsverstärkers 3 ist über einen weiteren Widerstand R2 mit dem negativen Eingang verbunden, so dass sich ein Differenzverstärker ergibt.

Der Stromwandler 1 liegt an einer Versorgungsspannung U_{CC} und am Massepotenzial M an. Der meist ringförmige Stromwandlerkern umschließt eine Leitung, durch die der zu messende Wechselstrom fließt. Der durch den Wechselstromverlauf hervorgerufene Magnetfluss im Stromwandlerkern wird mittels Hall-Sensor erfasst und in einen äquivalenten Spannungsverlauf umgewandelt. Dieser Spannungsverlauf wird mittels eines als Differenzverstärker beschalteten Operationsverstärkers verstärkt, wobei eine Referenzspannung U_{Ref} das Niveau jener Spannung bestimmt, die Null Ampere am Eingang entspricht. Am Ausgang des Stromwandlers liegt dann der noch nicht abgeglichene Verlauf des Messsignals U₀ an.

Bei der in Figur 1 dargestellten Variante mit diskreten Bauelementen erfolgt der Abgleich in der Weise, dass zunächst im Sample und Hold Verstärker 2 ein Korrekturwert ΔU gebildet wird. Dazu wird das am Eingang Uᵢₙ anliegende Messsignal U₀ bei jedem Impuls des am Zeitgeber-Eingang CK anliegenden Nulldurchgangssignals Sig angehalten. Der sich dabei ergebende Spannungswert gegen Massepotential M liegt dann bis zum nächsten Impuls des Nulldurchgangssignals Sig am Ausgang des Sample und Hold Verstärkers als Korrekturwert ΔU an.

Dieser Korrekturwert ΔU liegt somit auch am positiven Eingang des Operationsverstärkers 3 an. Das über den ersten Widerstand R1 am negativen Eingang anliegenden Messsignal U₀ ergibt dann am Ausgang des Operationsverstärkers das abgeglichene Messausgangssignal U_{OUT}. Die Widerstände R1 und R2 sind dabei so zu wählen, dass bei Null Ampere am Eingang des Stromwandlers das Messsignal U₀ der Referenzspannung U_{Ref} des Stromwandlers entspricht.

Anstelle der Schaltung mit Sample und Hold Verstärker und nachgeschaltetem Operationsverstärker kann auch ein Mikrocontroller angeordnet sein. Dieser Mikrocontroller weist dann zumindest zwei Eingänge und einen Ausgang auf, wobei am ersten Eingang das Messsignal U₀ und am zweiten Eingang das Nulldurchgangssignal Sig anliegen. Mit jedem Impuls des Nulldurchgangssignals Sig speichert der Mikrocontroller den momentanen Wert des Messsignals U₀ als Korrekturwert ΔU bis zum nächsten Impuls ab. Mittels Mikrocontroller wird dann das abgeglichene Messausgabesignal U_{OUT} in der Weise errechnet, dass der Korrekturwert ΔU vom Messsignal U₀ in Abzug gebracht wird. Das abgeglichene Messausgabesignal U_{OUT} ist am Ausgang des Mikrocontrollers abgreifbar.

In Figur 2 sind der zeitliche Verlauf des Netzstromes I_{NETZ} und das davon abgeleitete Nulldurchgangssignals Sig dargestellt. Das Nulldurchgangssignal Sig weist bei den Nulldurchgängen des Netzstromes I_{NETZ} im Wesentlichen rechteckige Impulse auf, wobei die Impulsdauer jener Zeitspanne entspricht, die der Umschaltvorgang der Schaltelemente im Wechselrichter bei der Umkehrung der Stromflussrichtung benötigt. Dieses Nulldurchgangssignal Sig wird dann entweder dem Sample und Hold Verstärker bei diskreter Bauteilanordnung oder dem Mikroprozessor zugeführt. Bei öffentlichen Stromnetzen ohne Phasenverschiebung zwischen Strom und Spannung kann auf diese Weise anstelle des Netzstromes auch die Netzspannung zur Ableitung des Nulldurchgangssignals dienen.

Für den Fall, dass beispielsweise in ein Inselnetz eingespeist wird, in dem Impedanzen mit nicht ausgleichbaren kapazitiven oder induktiven Anteilen wirken, eilt der Netzstrom der Netzspannung voraus oder hinterher. Dann ist das Nulldurchgangssignal Sig direkt von den Nulldurchgängen des Netzstromes abzuleiten. Da jedoch bei zur Netzeinspeisung vorgesehenen Wechselrichtern die Netzspannung ohnehin laufend erfasst wird, kann das Nulldurchgangssignal Sig auch aus den um die Phasenverschiebung korrigierten Nulldurchgängen der Netzspannung gebildet werden.

## Patentansprüche

1. Verfahren zum Messen eines mittels Wechselrichter erzeugten Wechselstromes (±Ip), welcher in ein Wechselstromnetz eingespeist wird, wobei ein Nulldurchgangssignal (Sig) des Wechselstromnetzes vorgegeben wird und einer Regelung des Wechselrichters ein Messsignal (U₀) des erzeugten Wechselstromes (±Ip) zugeführt wird, **dadurch gekennzeichnet, dass** ausgelöst vom Nulldurchgangssignal (Sig) ein periodischer Abgleich des Messsignals (U₀) in der Weise erfolgt, dass ein dem Nulldurchgangssignal (Sig) zugeordneter Abgleichwert vorgegeben wird, mit dem das Messignal (U₀) bis zum Beginn der nächsten Abgleichperiode abgeglichen wird.

2. Verfahren nach Anspruch 1, **dadurch gekennzeichnet, dass** jedem Nulldurchgang des Netzstromes (I_{NETZ}) ein Abgleichwert gleich Null Ampere zugeordnet wird und dass jeder beim Nulldurchgang des Netzstromes (I_{NETZ}) erfasste Messwert diesem Abgleichwert angeglichen wird.

3. Verfahren nach einem der Ansprüche 1 oder 2, **dadurch gekennzeichnet, dass** bei jeden Abgleich aus dem Abgleichwert und dem erfassten Messwert ein Korrekturwert (ΔU) ermittelt wird und dass bis zum nächsten Abgleich als Messausgabesignal (U_{OUT}) das mit dem Korrekturwert (ΔU) berichtigte Messsignal (U₀) ausgegeben wird.

4. Verfahren nach einem der Ansprüche 1 bis 3, **dadurch gekennzeichnet, dass** bei einem Wechselstromnetz ohne Phasenverschiebung die Messwerte zu den Zeitpunkten der Nulldurchgänge mit dem Abgleichwert abgeglichen werden.

5. Verfahren nach einem der Ansprüche 1 bis 3, **dadurch gekennzeichnet, dass** bei einem Inselnetz mit Phasenverschiebung die Messwerte zu den Zeitpunkten der Nulldurchgänge des Netzstromes mit dem Abgleichwert abgeglichen werden.

6. Verfahren nach Anspruch 5, **dadurch gekennzeichnet, dass** die Zeitpunkte der Nulldurchgänge des Netzstromes (I_{NETZ}) durch Erfassen der Netzspannung und der Phasenverschiebung bestimmt werden.

7. Anordnung, welche zur Durchführung der Verfahren nach einem der Ansprüche 1 bis 6 eingerichtet ist, **dadurch gekennzeichnet, dass** zur Messung des Wechselstromes (±Ip) ein Stromwandler (1) vorgesehen ist und dass am Eingang des Stromwandler (1) der vom Wechselrichter erzeugte Wechselstrom (±Ip) anliegt und dass am Ausgang eine Spannung als Messsignal (U₀) anliegt und dass das Messsignal (U₀) in Abhängigkeit vom Nulldurchgangssignal (Sig) periodisch dem Abgleichwert, welcher dem Nulldurchgangssignal (Sig) zugeordnet ist, angeglichen ist.

8. Anordnung nach Anspruch 7, **dadurch gekennzeichnet, dass** ein Mikrocontroller mit wenigstens zwei Eingängen vorgesehen ist und dass an einem ersten Eingang das vom Stromwandler (1) erzeugte Messsignal (U₀) sowie an einem zweiten Eingang das Nulldurchgangssignal (Sig) anliegen und dass des Weiteren dem Mikrocontroller ein dem Stromwert von Null Ampere zugeordneter Spannungswert (U_{Rer}) des Stromwandlers (1) als Abgleichwert vorgegeben wird und dass an einem Ausgang des Mikrocontrollers ein mit dem Korrekturwert (ΔU) berichtigtes Messausgabesignal abgreifbar ist.

9. Anordnung nach Anspruch 7, **dadurch gekennzeichnet, dass** ein so genannter Sample und Hold Verstärker (2) vorgesehen ist, an dessen Eingängen (Uᵢₙ, CK) das Messsignal (Uₒ) aus dem Stromwandler (1) und das Nulldurchgangssignal (Sig) anliegen und dass als Ausgangssignal ein Korrekturwert (ΔU) anliegt, der dem positiven Eingang eines Operationsverstärkers (3) zugeführt ist und dass des Weiteren am negativen Eingang des Operationsverstärkers (3) das Messsignal (U₀) anliegt, sodass am Ausgang des Operationsverstärkers (3) das berichtigte Messausgabesignal (U_{OUT}) abgreifbar ist.

## Claims

1. Method for measuring an alternating current (+Ip) generated by means of an inverter and fed into an AC power system, wherein a zero-crossing signal (Sig) of the AC power system is predefined and a measurement signal (U₀) of the generated alternating current (±Ip) is supplied for regulating the inverter,
**characterised in that**, triggered by the zero-crossing signal (Sig), a periodic adjustment of the measurement signal (U₀) takes place in such a way that an adjustment value assigned to the zero-crossing signal (Sig) is predefined and used to adjust the measurement signal (U₀) until the start of the next adjustment period.

2. Method according to claim 1, **characterised in that** an adjustment value equal to zero amperes is assigned to each zero crossing of the power system current (I_{NETZ}) and **in that** each measured value recorded at the zero crossing of the power system current (I_{NETZ}) is aligned to said adjustment value.

3. Method according to one of claims 1 or 2, **characterised in that** at each adjustment a correction value (ΔU) is determined from the adjustment value and the recorded measured value, and **in that** until the next adjustment the measurement signal (U₀) corrected by means of the correction value (ΔU) is output as the measurement output signal (U_{OUT}).

4. Method according to one of claims 1 to 3, **characterised in that** in an AC power system without phase shift the measured values are adjusted by means of the adjustment value at the time instants of the zero crossings.

5. Method according to one of claims 1 to 3, **characterised in that** in an isolated power system with phase shift the measured values are adjusted by means of the adjustment value at the time instants of the zero crossings of the power system current.

6. Method according to claim 5, **characterised in that** the time instants of the zero crossings of the power system current (I_{NETZ}) are determined by recording the power system voltage and the phase shift.

7. Arrangement which is configured for performing the methods according to one of claims 1 to 6, **characterised in that** a current transformer (1) is provided for the purpose of measuring the alternating current (±Ip) and **in that** the alternating current (±Ip) generated by the inverter is present at the input of the current transformer (1) and **in that** a voltage is present as the measurement signal (U₀) at the output and **in that** the measurement signal (U₀) is periodically aligned as a function of the zero-crossing signal (Sig) to the adjustment value that is assigned to the zero-crossing signal (Sig) .

8. Arrangement according to claim 7, **characterised in that** a microcontroller having at least two inputs is provided and **in that** the measurement signal (U₀) generated by the current transformer (1) is present at a first input and the zero-crossing signal (Sig) is present at a second input and **in that** in addition a voltage value (U_{Ref}) of the current transformer assigned to the current value of zero amperes is predefined for the microcontroller as an adjustment value and **in that** a measurement output signal corrected by means of the correction value (ΔU) can be tapped at an output of the microcontroller.

9. Arrangement according to claim 7, **characterised in that** a so-called sample-and-hold amplifier (2) is provided, at the inputs (Uᵢₙ, CK) of which the measurement signal (U₀) from the current transformer (1) and the zero-crossing signal (Sig) are present, and **in that** a correction value (ΔU) is present as the output signal, said correction value (ΔU) being supplied to the positive input of an operational amplifier (3) and **in that** in addition the measurement signal (U₀) is present at the negative input of the operational amplifier (3) such that the corrected measurement output signal (U_{OUT}) can be tapped at the output of the operational amplifier (3).

## Revendications

1. Procédé pour mesurer un courant alternatif (±Ip) généré au moyen d'un onduleur et injecté dans un réseau de courant alternatif, un signal de passage par zéro (Sig) du réseau de courant alternatif étant prédéfini et un signal de mesure (U₀) du courant alternatif généré (±Ip) étant amené à un réglage de l'onduleur, **caractérisé en ce que**, déclenchée par le signal de passage par zéro (Sig), un alignement périodique du signal de mesure (U₀) s'effectue de manière telle qu'est spécifiée une valeur d'alignement associée au signal de passage par zéro (Sig) avec laquelle le signal de mesure (U₀) est compensé jusqu'au début de la période d'alignement suivante.

2. Procédé selon la revendication 1, **caractérisé en ce qu'**une valeur d'alignement égale à zéro ampère est associée à chaque passage par zéro du courant de réseau (I_{NETZ}) et **en ce que** chaque valeur de mesure saisie au passage par zéro du courant de réseau (I_{NETZ}) est mise au niveau de cette valeur d'alignement.

3. Procédé selon l'une des revendications 1 ou 2, **caractérisé en ce qu'**une valeur de correction (ΔU) est déterminée à chaque alignement sur la base de la valeur d'alignement et de la valeur de mesure saisie et **en ce qu'**est émis en tant que signal de sortie de mesure (Uₒᵤₜ), jusqu' à l'alignement suivant, le signal de mesure (U₀) corrigé avec la valeur de correction (ΔU).

4. Procédé selon l'une des revendications 1 à 3, **caractérisé en ce que**, étant donné un réseau de courant alternatif sans déphasage, les valeurs de mesures sont avec la valeur d'alignement aux instants des passages par zéro.

5. Procédé selon l'une des revendications 1 à 3, **caractérisé en ce que**, étant donné un réseau en site isolé avec déphasage, les valeurs de mesures sont avec la valeur d'alignement aux instants des passages par zéro du réseau de courant alternatif.

6. Procédé selon la revendication 5, **caractérisé en ce que** les instants des passages par zéro du courant du réseau (I_{NETZ}) sont déterminés par détection de la tension de réseau et du déphasage.

7. Arrangement aménagé pour exécuter le procédé selon l'une des revendications 1 à 6, **caractérisé en ce qu'**un convertisseur de courant (1) est prévu pour mesurer le courant alternatif (±Ip) et **en ce que** le courant alternatif (±Ip) généré par l'onduleur est appliqué sur l'entrée du convertisseur de courant (1) et **en ce qu'**une tension est appliquée sur la sortie en tant que signal de mesure (U₀) et **en ce que** le signal de mesure (U₀) est, en fonction du signal de passage par zéro (Sig), mis périodiquement au niveau de la valeur d'alignement qui est associée au signal de passage par zéro (Sig).

8. Arrangement selon la revendication 7, **caractérisé en ce qu'**est prévu un microcontrôleur avec au moins deux entrées et **en ce que** le signal de mesure (U₀) généré par le convertisseur de courant (1) est appliqué sur une première entrée et le signal de passage par zéro (Sig) est appliqué sur une deuxième entrée et **en ce que**, de surcroît, une valeur de tension (U_{réf}) du convertisseur de courant (1) associée à la valeur du courant de zéro ampère est prescrite au microcontrôleur en tant que valeur d'alignement et **en ce qu'**un signal de sortie de mesure corrigé avec la valeur de correction (ΔU) peut être prélevé à une sortie du microcontrôleur.

9. Arrangement selon la revendication 7, **caractérisé en ce qu'**est prévu ce qu'il est convenu d'appeler un amplificateur d'échantillonnage et de maintient (2) sur les entrées (Uᵢₙ, CK) duquel sont appliqués le signal de mesure (U₀) issu du convertisseur de courant (1) et le signal de passage par zéro (Sig) et **en ce qu'**est appliquée, en tant que signal de sortie, une valeur de correction (ΔU) qui est envoyée sur l'entrée positive d'un amplificateur opérationnel (3) et **en ce que**, de surcroît, le signal de mesure (U₀) est appliqué sur l'entrée négative de l'amplificateur opérationnel (3) de sorte que le signal de sortie de mesure corrigé (Uₒᵤₜ) peut être prélevé à la sortie de l'amplificateur opérationnel (3).
